# EUROPEAN PATENT APPLICATION

(11) **EP 4 701 384 A1**
(43) Date of publication of application: **25.02.2026**
(21) Application number: 25190396.9
(22) Date of filing: 18.07.2025
(51) Int. Cl.: H10K 59/35, H10K 59/80, H10K 59/124, H10K 59/121, H10K 59/131

(54) **TRANSPARENT DISPLAY APPARATUS**

(30) Priority: 22.08.2024 KR 20240113087
(71) Applicant: LG Display Co., Ltd., Seoul, 07336 (KR)
(72) Inventor: KIM, Binn, 10845 Gyeonggi-do (KR); KIM, Dojin, 10845 Gyeonggi-do (KR)
(74) Representative: Viering, Jentschura & Partner mbB Patent- und Rechtsanwälte

(57) **Abstract**

A transparent display apparatus (100) according to an embodiment of the present disclosure comprises a substrate (110) including a display area (DA) having a transmissive area (TA) and a non-transmissive area (NTA) in which a plurality of subpixels (SP) are arranged; a plurality of inorganic film layers (111) provided on the substrate; an outermost signal line (EVDD, EVSS) arranged below an inorganic film layer at the lowermost side among the plurality of inorganic film layers (111); and a step portion (STP) at which at least one inorganic film layer among the plurality of inorganic film layers (111) is removed, the outermost signal line (EVDD, EVSS) is arranged at an edge portion of the non-transmissive area (NTA), and the step portion (STP) overlaps the outermost signal line (EVDD, EVSS).

## Description

### CROSS-REFERENCE TO RELATED APPLICATIONS

This application claims the benefit of the Korean Patent Application No. 10-2024-0113087 filed on August 22, 2024.

### BACKGROUND

### Field of the Invention

The present disclosure relates to a transparent display apparatus displaying images.

### Discussion of the Related Art

With the advancement of the information age, the demand for a display apparatus for displaying an image has increased in various forms. Therefore, various types of display apparatuses such as a liquid crystal display (LCD) apparatus, a plasma display panel (PDP) apparatus, an organic light emitting display (OLED) apparatus and a quantum dot light emitting display (QLED) apparatus have been recently used.

Recently, studies for a transparent display apparatus in which a user may view objects positioned at an opposite side by transmitting the display apparatus are actively ongoing.

The transparent display apparatus may include a display area, on which an image is displayed, in a substrate, and the display area may include a transmissive area capable of transmitting external light and a non-transmissive area that does not transmit light.

Meanwhile, a plurality of inorganic film layers may be arranged in the transmissive area of the transparent display apparatus, and at least one of these inorganic film layers may include an inorganic film layer with a different refractive index in consideration of adhesion to the substrate. However, inorganic film layers with different refractive indices reduce the transmittance of the transmissive area due to total reflection caused by the difference in refractive indices. Therefore, methods for removing inorganic film layers with different refractive indices are being studied, but when an inorganic film layer with different refractive indices is removed, a step portion is formed in other inorganic film layers formed on it. When this step portion is formed in the transmissive area, there is a problem of reduced clarity of objects that the user sees through the transmissive area.

### SUMMARY

The present disclosure is to provide a transparent display apparatus capable of improving the clarity of an object or image shown to a user through a transmissive area.

The present disclosure is to provide a transparent display apparatus in which the transmittance of the transmissive area may be improved.

The present disclosure is to provide a transparent display apparatus capable of reducing overall power consumption.

The technical benefits of the present disclosure are not limited to the above-mentioned benefits, and other benefits, which are not mentioned above, can be clearly understood by those skilled in the art from the following descriptions. According to an aspect of the present disclosure, a transparent display apparatus according to claim 1 is provided. Further embodiments of the transparent display apparatus are described in the dependent claims.

A transparent display apparatus according to at least one embodiment of the present disclosure comprises a substrate including a display area having a transmissive area and a non-transmissive area in which a plurality of subpixels are arranged; a plurality of inorganic film layers provided on the substrate; an outermost signal line arranged below an inorganic film layer at the lowermost side among the plurality of inorganic film layers; and a step portion at which at least one inorganic film layer among the plurality of inorganic film layers is removed, wherein the outermost signal line is arranged at an edge portion of the non-transmissive area, and the step portion overlaps the outermost signal line.

In one or more embodiments, the step portion is formed by removing a first inorganic film layer and a second inorganic film layer disposed on the first inorganic film layer and having a different refractive index from the first inorganic film layer.

In one or more embodiments, the first inorganic film layer and the second inorganic film layer are arranged to overlap only in the non-transmissive area.

In one or more embodiments, the first inorganic film layer is in contact with an upper surface of the substrate in the non-transmissive area, partially covering the outermost signal line.

In one or more embodiments, the first inorganic film layer includes SiNₓ, and the second inorganic film layer includes SiO₂.

In one or more embodiments, the substrate further includes a plurality of protective electrodes covering the step portion and a portion of the outermost signal line.

In one or more embodiments, each of the plurality of protective electrodes covers the end of the outermost signal line.

In one or more embodiments, each of the plurality of protective electrodes covering the step portion has a step.

In one or more embodiments, the substrate further includes a black matrix arranged between the plurality of subpixels, and at least one of the plurality of protective electrodes overlaps the black matrix.

In one or more embodiments, the outermost signal line is arranged in a first direction, and each of the plurality of protective electrodes is arranged in the first direction in the non-transmissive area and is electrically connected to the outermost signal line.

In one or more embodiments, each of the plurality of protective electrodes is provided in an island shape.

In one or more embodiments, the plurality of subpixels include a plurality of colored subpixels and a white subpixel arranged adjacent to each of the plurality of colored subpixels, wherein the plurality of protective electrodes include: a first protective electrode between the plurality of colored subpixels and the transmissive area; and a second protective electrode between the white subpixel and the transmissive area.

In one or more embodiments, the first protective electrode is positioned spaced apart from the transmissive area.

In one or more embodiments, the second protective electrode is positioned adjacent to the transmissive area.

In one or more embodiments, the substrate further includes a gate line arranged in a second direction intersecting the first direction, wherein the gate line is not electrically connected to each of the plurality of protective electrodes.

In one or more embodiments, each of the plurality of protective electrodes is arranged spaced apart from the gate line.

In one or more embodiments, each of the plurality of protective electrodes is formed of the same material as the gate line.

In one or more embodiments, the gate line includes a closed loop structure partially overlapping the outermost signal line, wherein each of the plurality of protective electrodes is not formed on a part of the outermost signal line overlapping the closed loop structure.

In one or more embodiments, the gate line partially covers the step portion.

In one or more embodiments, the part of the gate line covering the step portion is spaced apart from the outermost signal line and covers the outermost signal line.

In one or more embodiments, the plurality of inorganic film layers further include: a third inorganic film layer disposed on the second inorganic film layer; and a fourth inorganic film layer disposed on the third inorganic film layer, wherein the third inorganic film layer and the fourth inorganic film layer overlap in the transmissive area.

In one or more embodiments, the third inorganic film layer is in contact with an upper surface of the substrate in the transmissive area.

In one or more embodiments, the substrate further includes a black matrix arranged between the plurality of sub-pixels, wherein the step portion overlaps the black matrix.

In one or more embodiments, the plurality of sub-pixels include a plurality of color sub-pixels and a white sub-pixel, wherein the black matrix is arranged between each of the plurality of color sub-pixels and the transmissive area, and is not arranged between the white sub-pixel and the transmissive area.

In one or more embodiments, the substrate further comprises a bank between one of the plurality of colored subpixels and the white subpixel, wherein the bank partially overlaps the black matrix.

In one or more embodiments, a width of the black matrix is narrower than a width of the bank.

In one or more embodiments, an end of the third inorganic film layer and an end of the fourth inorganic film layer are arranged on the outermost signal line.

In one or more embodiments, the transparent display apparatus further comprises a planarization layer disposed on the fourth inorganic film layer, wherein the planarization layer contacts an upper surface of the substrate in the transmissive area.

A transparent display apparatus according to at least one embodiment comprises: a substrate including a display area having a plurality of pixels, each of which includes a transmissive area and a non-transmissive area; a first inorganic film layer; and a second inorganic film layer disposed on the first inorganic film layer, wherein the first inorganic film layer and the second inorganic film layer in the transmissive area and an edge portion of the non-transmissive area are removed, so that a step portion is formed in the non-transmissive area.

In one or more embodiments, the transparent display apparatus further comprises an outermost wiring arranged below the first inorganic film layer and overlapping with the step portion.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a plan view illustrating a transparent display apparatus according to one embodiment of the present disclosure.
FIG. 2 is a schematic enlargement of portion A of FIG. 1, showing a single pixel.
FIG. 3 is a schematic drawing showing a plurality of lines and protective electrodes in FIG. 2.
FIG. 4 is a schematic cross-sectional view taken along the line I-I' shown in FIG. 3.
FIG. 5 is a schematic cross-sectional view taken along the line II-II' shown in FIG. 3.
FIG. 6 is a schematic cross-sectional view taken along the line III-III' shown in FIG. 3.
FIG. 7 is a schematic cross-sectional view taken along the line IV-IV' shown in FIG. 3.
FIG. 8 is schematic cross-sectional view showing a transparent display apparatus according to another embodiment of the present disclosure.

### DETAILED DESCRIPTION OF THE DISCLOSURE

Reference will now be made in detail to the embodiments of the present disclosure, examples of which are illustrated in the accompanying drawings. Wherever possible, the same reference numbers will be used throughout the drawings to refer to the same or like parts. Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only~' is used. The terms of a singular form may include plural forms unless referred to the contrary. In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms.

These terms are only used to distinguish one element from another. For example, a first element could be termed a second element, and, similarly, a second element could be termed a first element, without departing from the scope of the present disclosure.

"X-axis direction", "Y-axis direction" and "Z-axis direction" should not be construed by a geometric relation only of a mutual vertical relation and may have broader directionality within the range that elements of the present disclosure may act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure may be partially or overall coupled to or combined with each other and may be variously inter-operated with each other and driven technically as those skilled in the art can sufficiently understand.

The embodiments of the present disclosure may be carried out independently from each other or may be carried out together in co-dependent relationship.

Hereinafter, the preferred embodiments of the present disclosure will be described in detail with reference to the accompanying drawings.

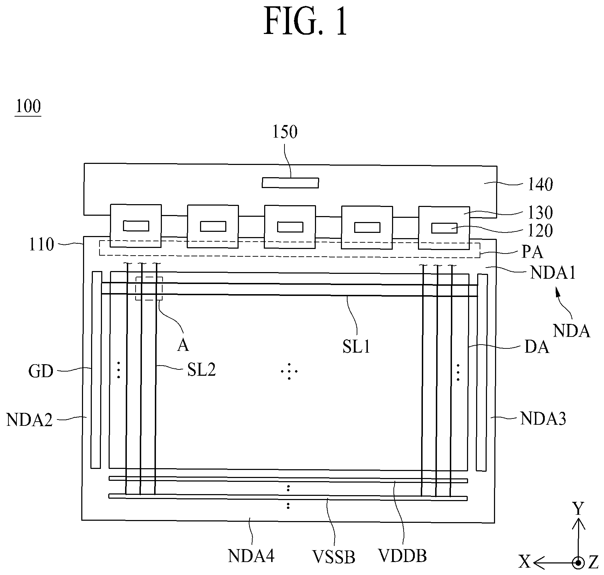

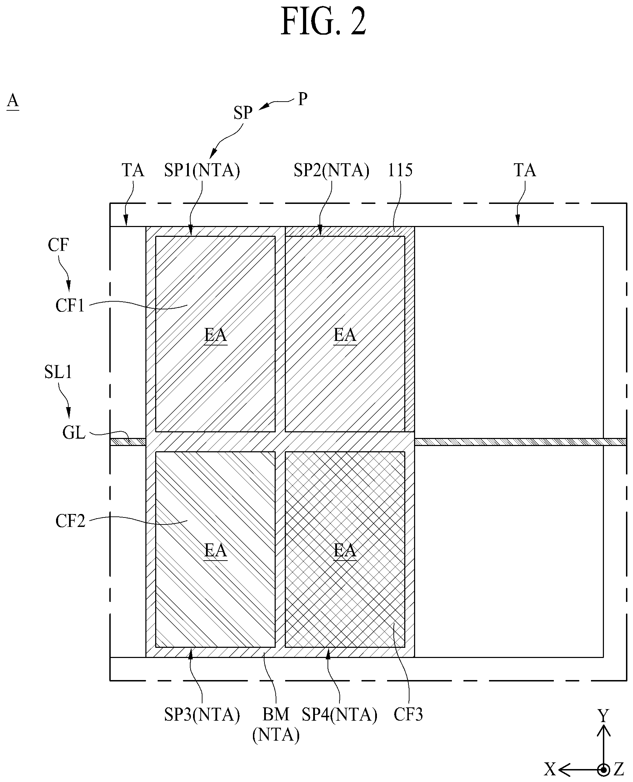

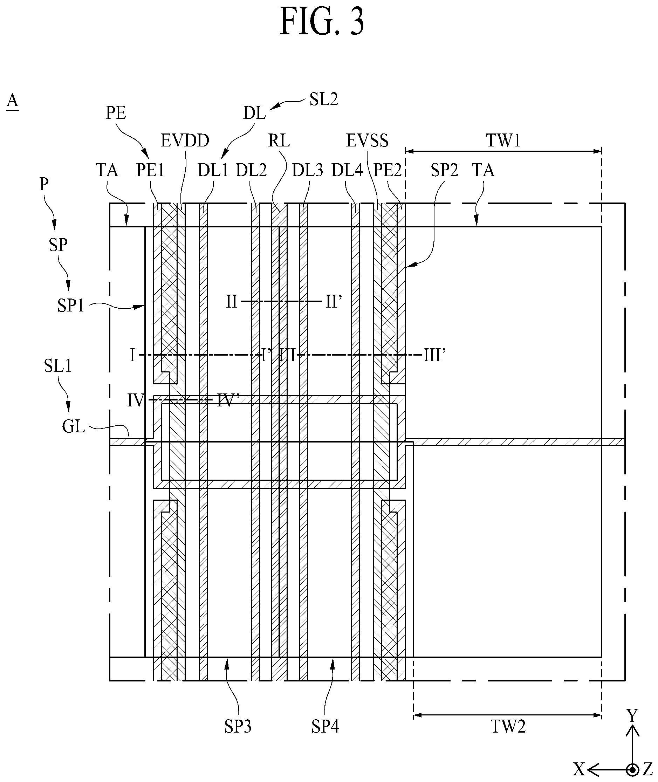

FIG. 1 is a plan view illustrating a transparent display apparatus according to one embodiment of the present disclosure, FIG. 2 is a schematic enlargement of portion A of FIG. 1, showing a single pixel, and FIG. 3 is a schematic drawing showing a plurality of lines and protective electrodes in FIG. 2.

Hereinafter, a first direction (Y-axis direction) indicates a direction parallel to the data line DL (shown in FIG. 3), a second direction (X-axis direction) indicates a direction parallel to a gate line GL (shown in FIG. 3), and a third direction (Z-axis direction) indicates a thickness direction of the transparent display apparatus 100.

The following description will be based on that a transparent display apparatus 100 according to one embodiment of the present disclosure is an organic light emitting display apparatus, but is not limited thereto. That is, the transparent display apparatus according to one embodiment of the present disclosure may be implemented as any one of a liquid crystal display apparatus, a field emission display apparatus, a quantum dot lighting emitting diode apparatus, and an electrophoretic display apparatus as well as the organic light emitting display apparatus.

Referring to FIGS. 1 to 3, the transparent display apparatus 100 according to one embodiment of the present disclosure may include a display panel having a gate driver GD, a source drive integrated circuit (hereinafter, referred to as "IC") 120, a flexible film 130, a circuit board 140, and a timing controller 150.

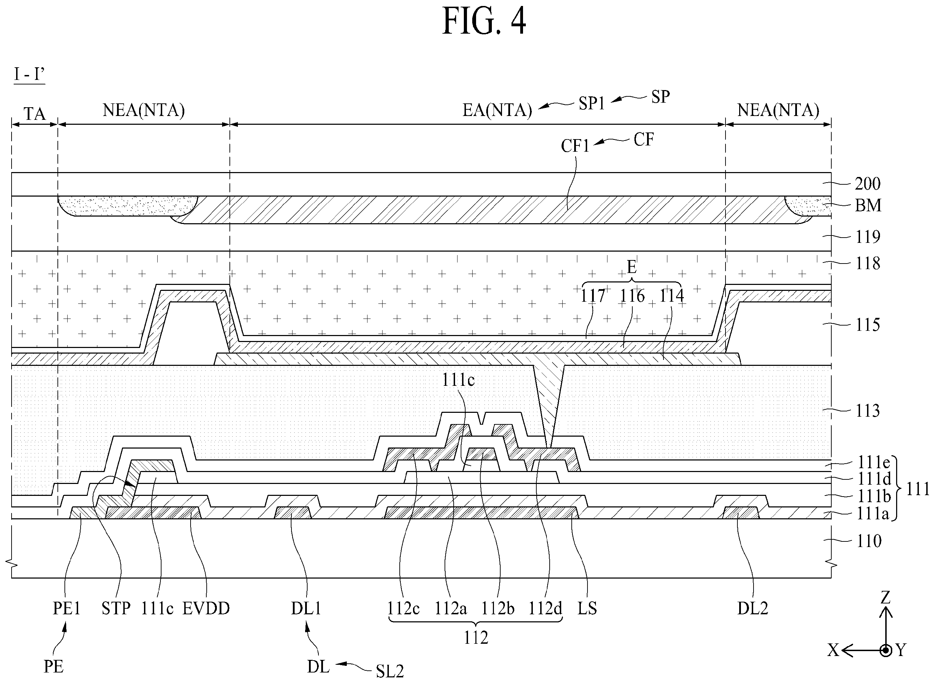

The display panel may include a substrate 110 and an opposite substrate 200 (shown in FIG. 4), which are bonded to each other.

The substrate 110 may include a thin film transistor, and may be a transistor array substrate, a lower substrate, a base substrate, or a first substrate. The substrate 110 may be a transparent glass substrate or a transparent plastic substrate.

The opposite substrate 200 may be bonded to the substrate 110 via an adhesive member. For example, the opposite substrate 200 may have a size smaller than that of the substrate 110, and may be bonded to the remaining portion except the pad area of the substrate 110. The opposite substrate 200 may be an upper substrate, a second substrate, or an encapsulation substrate.

The gate driver GD supplies gate signals to the gate lines in accordance with the gate control signal input from the timing controller 150. When the source drive IC 120 is manufactured as a driving chip, the source drive IC 120 may be mounted on the flexible film 130 in a chip on film (COF) method or a chip on plastic (COP) method.

Pads such as power pads and data pads may be formed in a non-display area of a display panel. A flexible film 130 may include lines connecting the pads to a source drive IC 120 and lines connecting the pads to lines of a circuit board 140. The flexible film 130 may be attached to the pads by using an anisotropic conducting film, whereby the pads may be connected to the lines of the flexible film 130.

Referring to FIG. 1, the substrate 110 according to an example may include a display area DA and a non-display area NDA.

The display area DA is an area where an image is displayed, and may be a pixel array area, an active area, a pixel array unit, a display unit, or a screen. For example, the display area DA may be disposed at a central portion of the display panel.

The display area DA according to an example may include gate lines, data lines, pixel driving power lines, and a plurality of pixels P (shown in FIG. 2). Each of the plurality of pixels P may include a plurality of sub-pixels SP that may be defined by the gate lines and the data lines, and a transmissive area TA disposed to be adjacent to some or all of the plurality of sub-pixels SP. The transmissive area TA is an area provided to allow light to transmit front and rear surfaces of the display panel. Therefore, a user located in the direction of the front surface of the display panel may view an image or background positioned in the direction of the rear surface of the display panel through the transmissive area TA.

As illustrated in FIG. 2, the remaining part of the display area DA excluding the transmissive area TA may be a non-transmissive area NTA. The transmissive area TA is an area that allows most of the light incident from the outside to pass through, and the non-transmissive area NTA is an area that does not allow most of the light incident from the outside to pass through.

The non-transmissive area NTA according to one example may include a light emission area EA of each of a plurality of subpixels SP and an area including a black matrix BM between the light emission areas EA. Since the area including the black matrix BM is an area where light is not emitted, it may be included in the non-light emission area NEA (shown in FIG. 4). The non-light emission area NEA according to an example may be provided between the transmissive area TA and the plurality of subpixels SP, and between the plurality of subpixels SP on the substrate 110.

Meanwhile, since the non-transmissive area NTA is an area through which light cannot be transmitted, if a bank 115 is provided as a black bank, the area where the black bank is arranged may also be included in the non-transmissive area NTA (or non-light emission area NEA). However, when the bank 115 is a transparent bank, a line or electrode (e.g., a second protective electrode PE2 (shown in FIG. 3)) located under the bank blocks light, so in this case, the area where the line or electrode (e.g., the second protective electrode PE2) is placed may be included in the non-transmissive area NTA (or non-light emission area NEA). As a result, objects or images on the opposite side of the user based on the substrate 110 can be recognized by the user only through the transmissive area TA.

Each of the plurality of sub-pixels SP may be defined as a minimum unit in which light is actually emitted.

According to one example, at least four sub-pixels SP1, SP2, SP3, SP4, which are provided to emit light of different colors and disposed to be adjacent to one another, among the plurality of sub-pixels, and one transmissive area TA constitute one unit pixel P. One transmissive area TA included in the unit pixel may be divided into a plurality of areas.

One unit pixel may include, but is not limited to, a red sub-pixel, a green sub-pixel, a blue sub-pixel, a white sub-pixel and a transmissive area TA. According to another example, three sub-pixels, which are provided to emit light of different colors and disposed to be adjacent to one another, among the plurality of sub-pixels SP, and one transmissive area TA constitute one unit pixel. One unit pixel may include at least one red sub-pixel, at least one green sub-pixel, at least one blue sub-pixel and one transmissive area TA, but is not limited thereto. Hereinafter, an example will be described in which one unit pixel P of a transparent display apparatus 100 according to one embodiment of the present disclosure includes four subpixels SP1, SP2, SP3, SP4 and one transmissive area TA.

Each of the plurality of sub-pixels SP may include a thin film transistor and a light emitting element connected to the thin film transistor. The sub-pixel may include a light emitting layer (or an organic light emitting layer) interposed between a first electrode and a second electrode.

The light emitting layer disposed in each of the plurality of sub-pixels SP1, SP2, SP3, SP4 may individually emit light of different colors, or may commonly emit white light. According to one example, when the light emitting layer of each of the plurality of sub-pixels SP commonly emits white light, each of the red sub-pixel, the green sub-pixel and the blue sub-pixel may include a color filter (or a wavelength conversion member) for converting the white light into light of different colors. In this case, the white sub-pixel according to one example may not include a color filter. The color filter CF, according to one example, can include a green color filter CF1, a blue color filter CF2, and a red color filter CF3.

In the transparent display apparatus 100 according to one embodiment of the present disclosure, an area in which a green color filter CF1 is provided may be a green sub-pixel SP1, an area in which a blue color filter CF2 is provided may be a blue sub-pixel SP3, an area in which a red color filter CF3 is provided may be a red sub-pixel SP4, and an area in which a color filter is not provided may be a white sub-pixel SP2. In the present disclosure, the green sub-pixel SP1 may be expressed as a first sub-pixel provided to emit green light, the blue sub-pixel SP3 may be expressed as a third sub-pixel configured to emit blue light, the red sub-pixel SP4 may be expressed as a fourth sub-pixel provided to emit red light, and the white sub-pixel SP2 may be represented as a second sub-pixel provided to emit white light.

As a result, the transparent display apparatus 100 according to one embodiment of the present disclosure may include a plurality of sub-pixels SP including a plurality of colored sub-pixels and a white sub-pixel SP2. According to one example, the plurality of colored sub-pixels may include a first sub-pixel SP1 which is a green sub-pixel, a third sub-pixel SP3 which is a blue sub-pixel, and a fourth sub-pixel SP4 which is a red sub-pixel.

Each of the plurality of sub-pixels SP supplies a predetermined current to the organic light emitting element in accordance with a data voltage of the data line when a gate signal is input from the gate line by using the thin film transistor. For this reason, the light emitting layer of each of the sub-pixels may emit light with a predetermined brightness in accordance with the predetermined current.

As shown in FIG. 1, in the display area DA, the plurality of pixels P and a plurality of lines for driving each of the plurality of pixels P can be disposed. The plurality of lines, according to one example, can include a plurality of first signal lines SL1 and a plurality of second signal lines SL2.

The plurality of first signal lines SL1 may be extended in the second direction (X-axis direction). Each of the plurality of first signal lines SL1 may include at least one scan line (or gate line).

Hereinafter, when the first signal line SL1 includes a plurality of lines, one first signal line SL1 may refer to a signal line group comprised of a plurality of lines. For example, when the first signal line SL1 includes two scan lines, one first signal line SL1 may refer to a signal line group comprised of two scan lines.

The plurality of second signal lines SL2 can extend in the first direction (Y-axis direction). The plurality of second signal lines SL2 can intersect with the plurality of first signal lines SL1. Each of the plurality of second signal lines SL2 can include a pixel power line EVDD, and a common power line EVSS disposed spaced apart from the pixel power line EVDD. In an embodiment, the plurality of second signal lines SL2 can further include a plurality of data lines DL, and a reference line RL. The plurality of data lines DL can include a first data line DL1 for driving a first sub-pixel SP1, a second data line DL2 for driving a second sub-pixel SP2, a third data line DL3 for driving a third sub-pixel SP3, and a fourth data line DL4 for driving a fourth sub-pixel SP4.

Hereinafter, when the second signal line SL2 includes a plurality of lines, one second signal line SL2 may refer to a signal line group comprised of a plurality of lines. For example, when the second signal line SL2 includes four data lines, a pixel power line, a common power line and a reference line, one second signal line SL2 may refer to a signal line group comprised of four data lines, a pixel power line, a common power line and a reference line.

At least one transmissive area TA may be disposed between the first signal lines SL1 adjacent to each other. In addition, at least one transmissive area TA may be disposed between the second signal lines SL2 adjacent to each other. That is, the transmissive area TA can be arranged adjacent to at least one of the first signal lines SL1 and at least one of the second signal lines SL2. However, it is not limited thereto, depending on the arrangement structure of the wiring, as shown in FIG. 3, the first signal line SL1 (or gate line GL) can be provided to cross the transmissive area TA in the second direction (X-axis direction).

Referring back to FIG. 1, the non-display area NDA is an area on which an image is not displayed, and may be a peripheral circuit area, a signal supply area, an inactive area or a bezel area. The non-display area NDA may be configured to be in the vicinity of the display area DA. That is, the non-display area NDA may be disposed to surround the display area DA.

The transparent display apparatus 100 according to one embodiment of the present disclosure can include a pad portion PA disposed in the non-display area NDA. The pad portion PA can be for driving the plurality of pixels P. For example, the pad portion PA can supply power and/or signals for the plurality of pixels P disposed in the display area DA to output images. The non-display area NDA can include a first non-display area NDA1, a second non-display area NDA2, a third non-display area NDA3, and a fourth non-display area NDA4. The pad portion PA according to one example can be disposed in the first non-display area NDA1.

The gate driver GD supplies gate signals to the gate lines in accordance with the gate control signal input from the timing controller 150. The gate driver GD may be formed on one side of the display area DA of the display panel or on the non-display area NDA outside both sides of the display area DA in a gate driver in panel (GIP) method as shown in FIG. 1. Alternatively, the gate driver GD may be manufactured as a driving chip, mounted on a flexible film and attached to the non-display area NDA outside one side or both sides of the display area DA of the display panel by a tape automated bonding (TAB) method.

The plurality of gate drivers GD may be separately disposed on a left side of the display area DA, that is, the second non-display area NDA2 and a right side of the display area DA, that is, the third non-display area NDA3. According to one example, the plurality of gate drivers GD may be connected to the plurality of pixels P and the plurality of first signal lines SL1 for supplying signals to the plurality of pixels P. The plurality of first signal lines SL1 may include at least one signal line for supplying a signal for driving the pixel P.

The plurality of second signal lines SL2 may be extended in the first direction (Y-axis direction). The plurality of second signal lines SL2 may cross the plurality of first signal lines SL1. The plurality of second signal lines may include a pixel power line EVDD and at least one data line to supply a data voltage to the pixel P. Each of the plurality of second signal lines SL2 may be connected to at least one of a plurality of pads, a pixel power shorting bar VDDB or a common power shorting bar VSSB. The pixel power shorting bar VDDB and the common power shorting bar VSSB may be disposed in the fourth non-display area NDA4 that is disposed to face the pad area PA based on the display area DA.

The pixels are provided to overlap at least one of the first signal line SL1 or the second signal line SL2 and emit predetermined light to display an image. The light emission area EA may correspond to an area, which emits light, in the pixel P.

Each of the green sub-pixel SP1 (or first sub-pixel SP1), the white sub-pixel SP2 (or second sub-pixel SP2), the blue sub-pixel SP3 (or third sub-pixel SP3), and the red sub-pixel SP4 (or fourth sub-pixel SP4) can comprise at least one or more light emission areas. The at least one light emission area of each of the sub-pixels SP1, SP2, SP3, SP4 can have the same shape and size, but is not necessarily limited thereto.

The non-light emission area NEA may refer to an area that is provided in the display area DA and does not emit light, and may be expressed as a dead zone because it does not emit light. The dead zone according to one example may be an area in which a black matrix and/or a bank is provided, but is not limited thereto, and may refer to an area in which light is not emitted.

The non-light emission area NEA can have the plurality of wirings, for example, first signal lines SL1 and second signal lines SL2 can be disposed. The first signal lines SL1 according to an example can include the gate line GL disposed extending in the second direction (X-axis direction). The second signal lines SL2 according to an example can include the pixel power line EVDD, the common power line EVSS, the reference line RL, and the plurality of data lines DL, which are extending in the first direction (Y-axis direction).

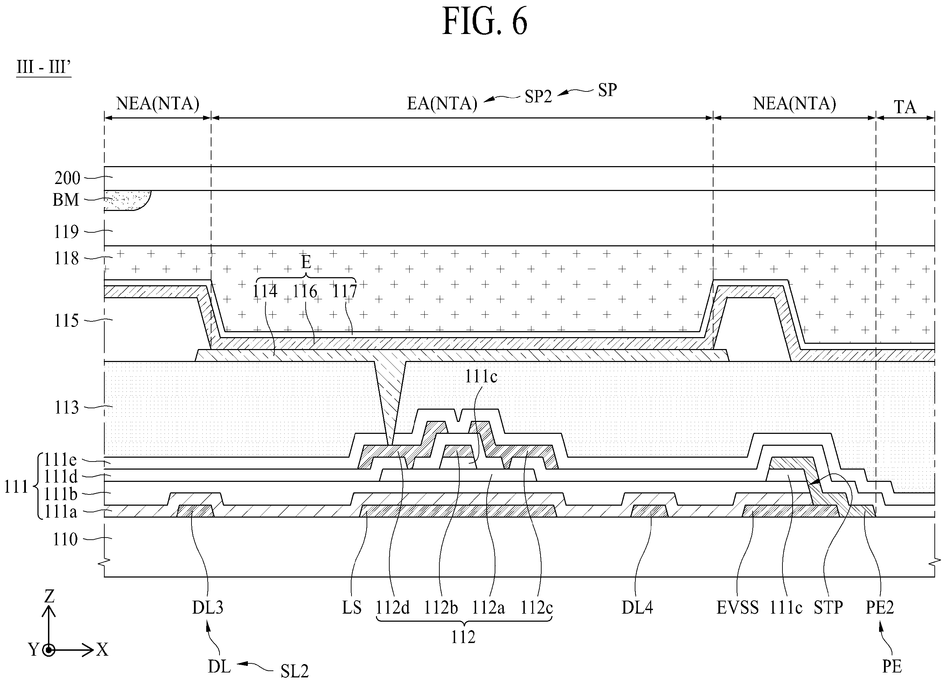

A transparent display apparatus 100 according to one embodiment of the present disclosure may include a plurality of protective electrodes PE partially overlapping with one of a plurality of lines, for example, a pixel power line EVDD (or a common power line EVSS) which is a line at the outermost edge portion of a non-transmissive area NTA. A plurality of protective electrodes PE are provided to protect the pixel power line EVDD (or common power line EVSS) from an etching material that etches at least one of the plurality of inorganic film layers. This will be described later with reference to FIGS. 4 and 6.

Hereinafter, with reference to FIGS. 4 to 7, a transparent display apparatus 100 according to one embodiment of the present disclosure will be described in more detail.

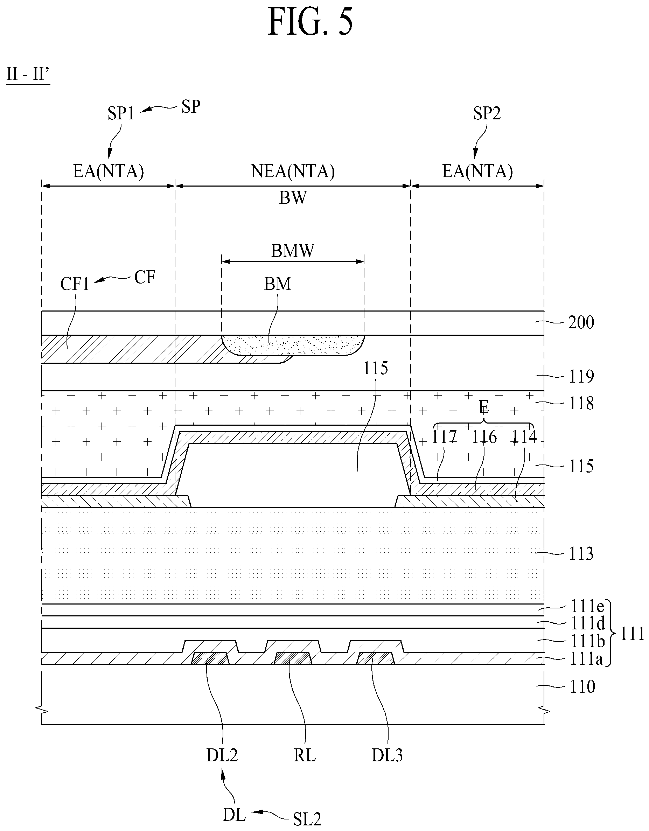

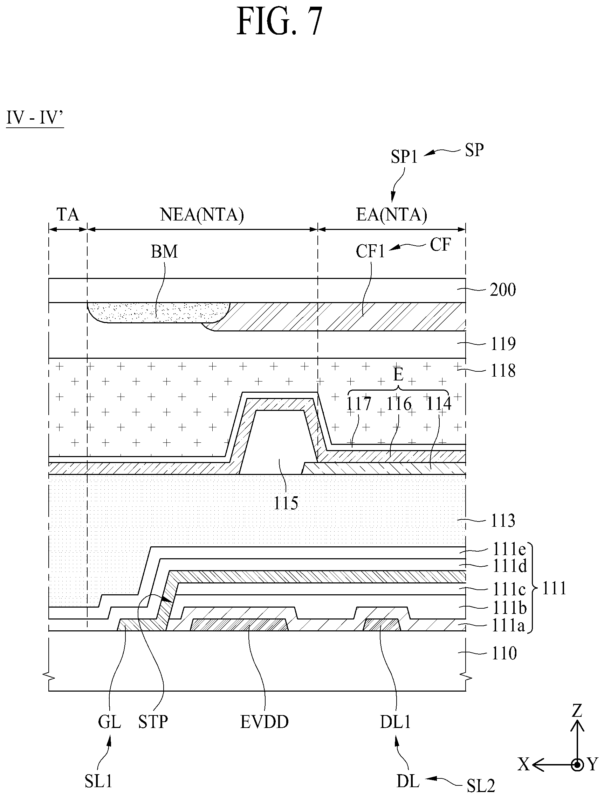

FIG. 4 is a schematic cross-sectional view taken along the line I-I' shown in FIG. 3, FIG. 5 is a schematic cross-sectional view taken along the line II-II' shown in FIG. 3, FIG. 6 is a schematic cross-sectional view taken along the line III-III' shown in FIG. 3, and FIG. 7 is a schematic cross-sectional view taken along the line IV-IV' shown in FIG. 3.

Referring to FIG. 4, a transparent display apparatus 100 according to one embodiment of the present disclosure may include a substrate 110 including a display area DA having a transmissive area TA and a non-transmissive area NTA in which a plurality of subpixels SP1, SP2, SP3, and SP4 are arranged, a plurality of inorganic film layers 111 arranged on the substrate 110, an outermost signal line arranged below an inorganic film layer at the lowermost side among the plurality of inorganic film layers 111, and a step portion STP at which at least one inorganic film layer among the plurality of inorganic film layers 111 is removed. The outermost signal line may be arranged at the edge portion of the non-transmissive area NTA. And, the step portion STP may overlap with the outermost signal line. Here, the outermost signal line may mean a pixel power line EVDD and/or a common power line EVSS. An edge portion of the non-transmissive area NTA where the outermost signal line is arranged may mean an edge portion of the non-light emission area NEA (shown in FIG. 3). Meanwhile, the outermost signal line may mean a signal line, but is not limited thereto, and may mean a power line. Therefore, in the present disclosure, the outermost signal line may also be referred to as the outermost wiring.

The plurality of inorganic film layers 111 are arranged between the substrate 110 and a light emitting element E to prevent moisture and oxygen from penetrating into the light emitting element E. In addition, at least one inorganic film layer among the plurality of inorganic film layers 111 may be arranged between a metal (or the outermost signal line) and the other inorganic film layer to compensate for weak adhesion between the metal (or the outermost signal line) and the other inorganic film layer.

For example, since the adhesion between a metal (or the outermost signal line) including copper Cu and an inorganic film layer including SiO₂ is poor, an inorganic film layer including SiNₓ may be placed between the metal (or the outermost signal line) and the SiO₂ inorganic film layer. Accordingly, the plurality of inorganic film layers 111 may include an inorganic film layer including SiNₓ (or a first inorganic film layer 111a) and an inorganic film layer including SiO₂ (or a second inorganic film layer 111b).

As described above, the inorganic film layer (or the first inorganic film layer 111a) containing SiNₓ is intended to increase the adhesion between the inorganic film layer (or the second inorganic film layer 111b) containing SiO₂ and the metal (or the outermost signal line), and therefore, it can be placed between the inorganic film layer (or the second inorganic film layer 111b) containing SiO₂ and the metal (or the outermost signal line). Accordingly, the metal (or the outermost signal line), the inorganic film layer including SiNₓ (or the first inorganic film layer 111a), and an inorganic film layer including SiO₂ (or the second inorganic film 111b) may be sequentially laminated on a substrate 110.

Therefore, in the transparent display apparatus 100 according to one embodiment of the present disclosure, the inorganic film layer at the lowermost side among the plurality of inorganic film layers 111 may be an inorganic film layer (or the first inorganic film layer 111a) containing SiNₓ. For example, the inorganic film layer (or the first inorganic film layer 111a) containing SiNₓ may be a first buffer layer. And, the inorganic film layer (or the second inorganic film layer 111b) containing SiO₂ may be a second buffer layer. As illustrated in FIG. 4, the second inorganic film layer 111b is disposed on the first inorganic film layer 111a and may include a portion that is thicker than the first inorganic film layer 111a. Accordingly, the second inorganic film layer 111b may flatten the uneven structure of the first inorganic film layer 111a.

Meanwhile, since the inorganic film layer (or the first inorganic film layer 111a) containing SiNₓ is made of a different material from the inorganic film layer (or the second inorganic film layer 111b) containing SiO₂, their refractive indices may be different from each other. Therefore, total reflection may occur at the interface between the inorganic film containing SiNₓ layer (or the first inorganic film layer 111a) and the inorganic film layer containing SiO₂ (or the second inorganic film layer 111b), which may result in a decrease in the transmittance (or transparency) of the transparent display apparatus. Therefore, in the case of a general transparent display apparatus, the inorganic film layer containing SiNₓ is removed to improve transparency, but when the inorganic film layer containing SiNₓ is removed, a step portion (or thin film step) is created in other inorganic film layers disposed on the inorganic film layer containing SiNₓ, which may increase the haze value. For example, when a step portion (or thin film step) at which an inorganic film layer including SiNₓ is removed is formed in a transmissive area, light of an object or image passing through the transmissive area may be diffracted by the step portion (or thin film step), thereby increasing the haze value. Therefore, in the case of a general transparent display apparatus, the clarity of an object or image may be reduced due to the step portion (or thin film step) formed in the transmissive area.

In contrast, a transparent display apparatus 100 according to one embodiment of the present disclosure may be provided such that the step portion STP at which at least one of the plurality of inorganic film layers 111 is removed overlaps the outermost signal line (the pixel power line EVDD or the common power line EVSS) arranged in a non-transmissive area NTA (or an edge portion of the non-transmissive area NTA).

For example, a transparent display apparatus 100 according to one embodiment of the present disclosure may include the step portion STP in which a first inorganic film layer 111a including SiNₓ and a second inorganic film layer 111b including SiO₂ are removed to improve transmittance (or transparency), and the step portion STP may be disposed on an outermost signal line (the pixel power line EVDD or the common power line EVSS) disposed in a non-transmissive area NTA (or an edge portion of the non-transmissive area NTA). Accordingly, as shown in FIG. 4, the step portion STP may overlap with the outermost signal line (or the pixel power line EVDD) in the third direction (Z-axis direction), and as shown in FIG. 6, the step portion STP can overlap with the outermost signal line (or the common power line EVSS) in the third direction (Z-axis direction). A transparent display apparatus 100 according to one embodiment of the present disclosure is provided such that the step portion STP overlaps with an outermost signal line (the pixel power line EVDD or the common power line EVSS), thereby reducing haze and further improving clarity compared to a general transparent display apparatus in which a step portion is arranged in a transmissive area.

In a transparent display apparatus 100 according to one embodiment of the present disclosure, the step portion STP may be formed by the first inorganic film layer 111a and the second inorganic film layer 111b. However, it is not limited thereto, and the step portion STP may be formed only by the first inorganic film layer 111a. Hereinafter, an example in which the step portion STP is formed by the first inorganic film layer 111a and the second inorganic film layer 111b will be described.

According to one example, the second inorganic film layer 111b is disposed on the first inorganic film layer 111a and may have a different refractive index from the first inorganic film layer 111a. For example, the first inorganic film layer 111a may be the first buffer layer including SiNₓ. The second inorganic film layer 111b may be the second buffer layer including SiO₂.

According to one embodiment of the present disclosure, a transparent display apparatus 100 is configured such that a first inorganic film layer 111a and a second inorganic film layer 111b having different refractive indices are not disposed in a transmissive area TA but are overlapped only in a non-transmissive area NTA, thereby preventing a plurality of inorganic film layers having different refractive indices from being disposed in a transmissive area, thereby improving the transmittance (or transparency). In addition, in a transparent display apparatus 100 according to one embodiment of the present disclosure, the step portion STP formed by removing a first inorganic film layer 111a and a second inorganic film layer 111b having different refractive indices is arranged on the outermost signal line (the pixel power line EVDD or the common power line EVSS) in the non-transmissive area NTA (or the edge portion of the non-transmissive area (NTA)), so that the outermost signal line (the pixel power line EVDD or the common power line EVSS) may prevent light of an object or image from being incident into the interior of the substrate 110, thereby preventing diffraction. Therefore, the transparent display apparatus 100 according to one embodiment of the present disclosure may have improved clarity (purity) due to a reduction in the haze value.

Referring to FIG. 4, in a transparent display apparatus 100 according to one embodiment of the present disclosure, the first inorganic film layer 111a may be in contact with an upper surface of the substrate 110 in the non-transmissive area NTA while partially covering the outermost signal line (hereinafter, the pixel power line EVDD will be described as an example).

As described above, in the transparent display apparatus 100 according to one embodiment of the present disclosure, the first inorganic film layer 111a includes SiNₓ, and therefore may be placed only in the non-transmissive area NTA to increase the transmittance. And, since the first inorganic film layer 111a contains SiNₓ, it can be placed between the second inorganic film layer 111b containing SiO₂ and a plurality of lines (for example, the outermost signal line (the pixel power line EVDD)) to increase adhesive strength. Accordingly, the second inorganic film layer 111b may be attached to the plurality of lines (e.g., the outermost signal lines (the pixel power lines EVDD)) through the first inorganic film layer 111a, and thus, the adhesive strength between the second inorganic film layer 111b and the plurality of lines (e.g., the outermost signal lines (the pixel power lines EVDD)) may be strengthened.

As shown in FIG. 4, the first inorganic film layer 111a is arranged as a common layer in the non-transmissive area NTA between the second inorganic film layer 111b and the plurality of lines to cover each of the plurality of lines, so that it may partially cover the outermost signal line (e.g., the pixel power line EVDD) located at the outermost part of the non-transmissive area NTA among the plurality of lines and come into contact with the upper surface of the substrate 110 located in the non-transmissive area NTA.

Meanwhile, since the step portion STP is arranged on the outermost signal line (e.g., the pixel power line EVDD), a part of the outermost signal line (e.g., the pixel power line EVDD) may be provided so as not to be covered by the first inorganic film layer 111a and the second inorganic film layer 111b. Therefore, a part of the outermost signal line (e.g., the pixel power line EVDD) may be exposed to the etching material of other inorganic film layers formed in a subsequent process, which may cause damage to the outermost signal line (e.g., the pixel power line EVDD). Therefore, in the transparent display apparatus 100 according to one embodiment of the present disclosure, the substrate 110 may further include a plurality of protective electrodes PE for protecting the outermost signal lines (e.g., the pixel power lines EVDD).

The plurality of protective electrodes PE according to one example are for protecting the outermost signal lines (e.g., the pixel power lines EVDD) from etching materials that etch the inorganic film layer. Accordingly, as illustrated in FIG. 4, each of the plurality of protective electrodes PE may be provided to cover a portion of the outermost signal line (e.g., the pixel power line EVDD) that is not covered by the first inorganic film layer 111a and the second inorganic film layer 111b, and the step portion STP. The step portion STP may be a part of the first inorganic film layer 111a and a part of the second inorganic film layer 111b. In addition, a part of the outermost signal line (e.g., the pixel power line EVDD) may be an end portion of the outermost signal line adjacent to the transmissive area TA. Additionally, each of the plurality of protective electrodes may be provided to cover a gate insulating film layer 111c provided in an island shape on the second inorganic film layer 111b. Accordingly, each of the plurality of protective electrodes PE may be provided in a step-like form and may be in contact with the upper surface of the substrate 110, a part of the upper surface and a side surface of the outermost signal line (e.g., the pixel power line EVDD), a side surface of the first inorganic film layer 111a, a side surface of the second inorganic film layer 111b, and the side surface and the upper surface of the gate insulating film layer 111c. Accordingly, as shown in Fig. 4, each of the plurality of protective electrodes PE covering the step portion STP can have a step. Each of the plurality of protective electrodes PE according to one example may be made of the same material as the outermost signal line (e.g., the pixel power line EVDD) to strengthen adhesion to the outermost signal line (e.g., the pixel power line EVDD). For example, each of the plurality of protective electrodes PE may be made of a metal material. As shown in FIG. 4, in the transparent display apparatus 100 according to one embodiment of the present disclosure, at least one of the plurality of protective electrodes PE may overlap with a black matrix BM.

Meanwhile, the gate insulating film layer 111c provided in an island shape on an upper surface of the second inorganic film layer 111b is arranged adjacent to the step portion STP, and thus may be expressed in terms of a step portion insulating film layer. In contrast, the gate insulating film layer 111c provided in an island shape on an upper surface of the active layer 112a of the thin film transistor 112 is arranged adjacent to the active layer 112a, and thus can be expressed in terms of an active layer insulating film layer.

In a transparent display apparatus 100 according to one embodiment of the present disclosure, the plurality of protective electrodes PE may be formed together when a gate line GL is formed. Therefore, the transparent display apparatus 100 according to one embodiment of the present disclosure may form the plurality of protective electrodes PE for protecting the outermost signal line (e.g., the pixel power line EVDD) without adding a separate process. Since the plurality of protective electrodes PE are formed together with the gate line GL, they may be formed on the same layer as the gate line GL. For example, the plurality of protective electrodes PE may be arranged on the gate insulating film layer 111c. In addition, since the plurality of protective electrodes PE are formed together with the gate line GL, they may be formed of the same material as the gate line GL.

Meanwhile, as illustrated in FIG. 3, the outermost signal line (e.g., the pixel power line EVDD) may be arranged long in the first direction (Y-axis direction). This is to apply voltage to each of the plurality of pixels P (or the plurality of sub-pixels SP) arranged adjacently in the first direction (Y-axis direction). Accordingly, each of the plurality of protective electrodes PE for covering a portion of the outermost signal line (e.g., the pixel power line EVDD) may be electrically connected to the outermost signal line (e.g., the pixel power line EVDD) while being arranged long in the first direction (Y-axis direction) in the non-transmissive area NTA.

A transparent display apparatus 100 according to one embodiment of the present disclosure is provided with a plurality of protective electrodes PE to partially cover an outermost signal line (e.g., the pixel power line EVDD), so that the outermost signal line (e.g., the pixel power line EVDD) may be protected from an etching material of the inorganic film layer. In addition, the transparent display apparatus 100 according to one embodiment of the present disclosure is provided such that the plurality of protective electrodes PE are electrically connected to the outermost signal line (e.g., the pixel power line EVDD), so that the plurality of protective electrodes PE may function as auxiliary electrodes. Accordingly, the transparent display apparatus 100 according to one embodiment of the present disclosure may prevent a voltage applied to the plurality of pixels P (or the plurality of sub-pixels SP) through the outermost signal line (e.g., the pixel power line EVDD) from being lowered (or dropped).

In a general transparent display apparatus, a voltage drop may occur when the voltage supplied from the edge portion of the display panel is applied to the center of the display panel. Therefore, the general transparent display apparatus has a problem in that a luminance of the image emitted from the edge portion and center of the display panel is uneven. In addition, a general large-area transparent display apparatus has the problem of increasing overall power consumption because the display panel must be driven at high power to solve the problem of uneven luminance of the image as above.

However, since the transparent display apparatus 100 according to one embodiment of the present disclosure is provided so that the plurality of protective electrodes PE are connected to the outermost signal lines (e.g., the pixel power lines EVDD and/or the common power lines EVSS), the plurality of protective electrodes PE may be used as auxiliary electrodes (or auxiliary lines), so that voltage drop in the central portion of the display panel may be prevented. Therefore, the transparent display apparatus 100 according to one embodiment of the present disclosure may make the luminance of the edge portion and the center portion of the display panel uniform.

In addition, the transparent display apparatus 100 according to one embodiment of the present disclosure is provided such that the plurality of protective electrodes PE are connected to the outermost signal lines (e.g., the pixel power lines EVDD and/or the common power lines EVSS), so that voltage drop in the center portion of the display panel may be prevented, and thus luminance of the edge portion and the center portion of the display panel may be made uniform with low power, so that the overall power consumption may be reduced.

Referring again to FIG. 3, in the transparent display apparatus 100 according to one embodiment of the present disclosure, the substrate 110 may further include a gate line GL (or a scan line GL) arranged in the second direction (X-axis direction) intersecting the first direction (Y-axis direction).

As shown in FIG. 3, the gate line GL (or the scan line GL) may be arranged in a direction (the second direction (X-axis direction)) crossing the outermost signal line (e.g., the pixel power line EVDD and/or the common power line EVSS). According to one example, the gate line GL (or the scan line GL) may be provided in a square shape in order to apply a gate voltage (or a gate signal) to each of the first to fourth sub-pixels SP1, SP2, SP3, and SP4, but is not necessarily limited thereto.

The gate line GL (or the scan line GL) may apply a different voltage (or signal) than the outermost signal line (e.g., the pixel power line EVDD and/or the common power line EVSS). As described above, each of the plurality of protective electrodes PE is electrically connected to the line outermost signal line (e.g., the pixel power line EVDD and/or the common power line EVSS), and thus may not be electrically connected to the gate line GL (or the scan line GL) to which a different voltage (or signal) is applied than the outermost signal line (e.g., the pixel power line EVDD and/or the common power line EVSS). Accordingly, each of the plurality of protective electrodes PE may be provided with a structure (or a discontinuous structure) that is disconnected based on the gate line GL (or the scan line GL). Therefore, as shown in Fig. 3, each of the plurality of protective electrodes PE may be provided in an island shape that is disconnected in the first direction (Y-axis direction). As shown in FIG. 3, each of the plurality of protective electrodes PE may be arranged spaced apart from the gate line GL. For example, each of the plurality of protective electrodes PE may be arranged spaced apart from the gate line GL in the first direction (Y-axis direction).

Meanwhile, as shown in FIG. 3, the gate line GL may include a closed loop structure that partially overlaps with the outermost signal line (e.g., the pixel power line EVDD). As described above, since each of the plurality of protective electrodes PE may be arranged to be spaced apart from the gate line GL in the first direction (Y-axis direction), the plurality of protective electrodes PE may not be formed on the outermost signal line (e.g., the pixel power line EVDD and/or the common power line EVSS) that overlaps the closed loop structure.

According to one example, the plurality of protective electrodes PE may include a first protective electrode PE1 and a second protective electrode PE2.

According to one example, the first protective electrode PE1 may be disposed between the plurality of colored subpixels and the transmissive area TA. For example, the first protective electrode PE1 may be disposed between the first subpixel SP1, which is the green subpixel (or a light emission area EA of the first subpixel SP1) and the transmissive area TA. According to an example, the second protective electrode PE2 may be disposed between a white subpixel SP2 and the transmissive area TA.

Meanwhile, in a transparent display apparatus 100 according to one embodiment of the present disclosure, the substrate 110 may further include a black matrix BM arranged between a plurality of subpixels SP. The black matrix BM is intended to prevent light from being emitted from an emitting subpixel to a non-emitting subpixel. Accordingly, the black matrix BM may be arranged between a plurality of subpixels SP, and may be arranged adjacent to the light emission area EA of each of the plurality of subpixels SP.

Additionally, the black matrix BM may be positioned between the plurality of subpixels SP and the transmissive area EA. In one example, the black matrix BM may be positioned between each of the plurality of colored subpixels SP1, SP3, SP4 and the transmissive area TA. However, the black matrix BM may not be placed between the transmissive area TA and the second subpixel SP2 which is a white subpixel. Since the second subpixel SP2 is provided to emit white light and therefore is not provided with a color filter, if there is no black matrix BM between the second subpixel SP2 and the transmissive area TA, a width TW1 of the transmissive area TA adjacent to the second subpixel SP2 may be formed to be relatively larger than a width TW2 of the transmissive area TA adjacent to other colored subpixels SP. For example, the width TW1 of the transmissive area TA adjacent to the second subpixel SP2, which is a white subpixel, may be provided to be larger than a width TW2 of the transmissive area TA adjacent to the fourth subpixel SP4, which is a red subpixel.

Therefore, since the transparent display apparatus 100 according to one embodiment of the present disclosure does not have the black matrix BM between and the transmissive area TA and the second subpixel SP2 which is a white subpixel, the transmittance (or transmittance) may be improved due to an increase in an area of the transmissive area TA adjacent to the second subpixel SP2.

Referring again to FIG. 4, the step portion STP may be superimposed on the black matrix BM. As described above, since the black matrix BM is positioned between a plurality of colored subpixels and the transmissive area TA, it may partially overlap with the outermost signal lines (e.g., the pixel power lines EVDD), which are lines located at the outermost edge of the non-transmissive area NTA. Therefore, the step portion STP placed on the outermost signal line (e.g., the pixel power line EVDD) may overlap the black matrix BM. As a result, the transparent display apparatus 100 according to one embodiment of the present disclosure is provided such that the step portion STP is double-overlapped with the outermost signal line (e.g., the pixel power line EVDD) and the black matrix BM, thereby maximizing prevention of diffraction phenomenon and maximizing improvement in the clarity of objects or images shown to the user through the transmissive area TA.

Meanwhile, in the transparent display apparatus 100 according to one embodiment of the present disclosure, the first protective electrode PE1 may be arranged spaced apart from the transmissive area TA. As shown in FIG. 4, the black matrix BM may be arranged between the transmissive area TA and the first subpixel SP1 which is a colored subpixel. The black matrix BM may be formed to protrude further toward the transmissive area TA than the first protective electrode PE1 so that the first protective electrode PE1 is not visible to the user. Accordingly, the transparent display apparatus 100 according to one embodiment of the present disclosure may include a structural feature in which the first protective electrode PE1 is arranged spaced apart from the transmissive area TA.

In contrast, in the transparent display apparatus 100 according to one embodiment of the present disclosure, the second protective electrode PE2 may be arranged adjacent to the transmissive area TA. As shown in FIG. 6, the black matrix BM may not be provided between the transmissive area TA and the second subpixel SP2 which is a white subpixel, and to improve transmittance. Accordingly, the transparent display apparatus 100 according to one embodiment of the present disclosure may include a structural feature in which the second protective electrode PE2 is arranged adjacent to the transmissive area TA. Therefore, as shown in FIG. 3, the second protective electrode PE2 may be arranged between the second subpixel SP2 and the transmissive area TA in a plane view.

Hereinafter, with reference to FIG. 4, the structure of each of the plurality of sub-pixels SPs will be described in detail.

Referring to FIG. 4, the transparent display apparatus 100 according to one embodiment of the present disclosure may include a plurality of inorganic film layers 111, a thin film transistor 112, a planarization layer 113, a pixel electrode 114, a bank 115, an organic light emitting layer 116, an opposing electrode 117, a filling layer 118, an upper organic film layer 119, a color filter CF, and a black matrix BM.

According to one example, the plurality of inorganic film layers 111 may include a first inorganic film layer 111a, a second inorganic film layer 111b, a gate insulating layer 111c, a third inorganic film layer 111d, and a fourth inorganic film layer 111e.

The first inorganic film layer 111a may be arranged between the substrate 110 and the second inorganic film layer 111b. According to one example, the first inorganic film layer 111a may be provided to cover all or part of each of the plurality of lines. The first inorganic film layer 111a may include SiNₓ. The first inorganic film layer 111a may be a first buffer layer.

The second inorganic film layer 111b may be disposed on the first inorganic film layer 111a. According to one example, the second inorganic film layer 111b may have a different refractive index from the first inorganic film layer 111a. The second inorganic film layer 111b may include SiO₂. The second inorganic film layer 111b may be a second buffer layer.

The gate insulating layer 111c may be disposed on the second inorganic film layer 111b. The gate insulating layer 111c is for insulating the active layer 112a and the gate electrode 112b of the thin film transistor 112. The gate insulating layer 111c formed on the step portion STP may be formed together with the gate insulating layer 111c of the thin film transistor 112. As shown in FIG. 4, the gate insulating layer 111c may be provided in an island shape on the thin film transistor 112 and/or the step portion STP.

The first inorganic film layer 111a and the second inorganic film layer 111b may be formed between the substrate 110 and the gate insulating layer 111c to protect the thin film transistor 112. A transparent display apparatus 100 according to one embodiment of the present disclosure may have the first inorganic film layer 111a and the second inorganic film layer 111b partially disposed on one side (or front side) of the substrate 110 in the non-transmissive area NTA to improve the transmittance of a transmissive area TA. Between the first inorganic film layer 111a and the substrate 110, an outermost signal line (e.g., a pixel power line EVDD) for pixel driving may be arranged. The outermost signal line (e.g., the pixel power line EVDD) may be arranged to be spaced apart from the thin film transistor 112 and partially overlap with the bank 115. As shown in Fig. 5, the reference line RL may also be placed between the first inorganic film layer 111a and the substrate 110. The reference line RL may be placed in the non-light emission area NEA (or the non-transmissive area NTA) that does not overlap with the light emission area EA. The first inorganic film layer 111a and the second inorganic film layer 111b may also play a role in blocking a substance contained in the substrate 110 from diffusing into a transistor layer during a high-temperature process during the manufacturing process of the thin film transistor.

The third inorganic film layer 111d may be disposed on the second inorganic film layer 111b. According to one example, the third inorganic film layer 111d may be disposed under the source electrode 112c and the drain electrode 112d. The third inorganic film layer 111d may be an interlayer insulating film.

The fourth inorganic film layer 111e may be disposed on the third inorganic film layer 111d. According to one example, the fourth inorganic film layer 111e may be provided to cover the source electrode 112c and the drain electrode 112d. The fourth inorganic film layer 111e may be provided as a common layer under the planarization layer 113, thereby protecting the light-emitting element from moisture and oxygen. The fourth inorganic film layer 111e may be a passivation film.

Thin film transistors 112 for driving subpixels SP may be arranged on the plurality of inorganic film layers 111. The plurality of inorganic film layers 111 may also be expressed in terms of a circuit element layer. The pixel electrode 114, the organic light-emitting layer 116, and the opposing electrode 117 arranged on the planarization layer 113 may be included in the light-emitting element layer E.

The thin film transistor 112 (or a drive transistor) according to an example may include an active layer 112a, a gate electrode 112b, a source electrode 112c, and a drain electrode 112d.

The active layer 112a may include a channel area, a drain area and a source area, which are formed in a thin film transistor area of a circuit area of the subpixel SP. The drain area and the source area may be spaced apart from each other with the channel area interposed therebetween.

The active layer 112a may be formed of a semiconductor material based on any one of amorphous silicon, polycrystalline silicon, oxide and organic material.

The gate insulating layer 111a may be formed on the channel area of the active layer 112a. As an example, the gate insulating layer 111a may be formed in an island shape on the channel area of the active layer 112a.

The gate electrode 112b may be formed on the gate insulating layer 111a to overlap the channel area of the active layer 112a.

The third inorganic film layer 111d may be formed on the gate electrode 112b and the drain area and the source area of the active layer 112a. As in Figure 4, the third inorganic film layer 111d may be formed in an entire light emission area, in which light is emitted from the subpixel SP. However, embodiments of the present disclosure are not limited thereto, the third inorganic film layer 111d may be patterned between the drain electrode 112d and the gate electrode 112b and drain region of the active layer 112a and may be arranged in an island shape, and moreover, may be patterned between the source electrode 112c and the gate electrode 112b and source region of the active layer 112a and may be arranged in an island shape.

The source electrode 112c may be electrically connected to the source area of the active layer 112a through a source contact hole provided in the third inorganic film layer 111d overlapped with the source area of the active layer 112a. The drain electrode 112d may be electrically connected to the drain area of the active layer 112a through a drain contact hole provided in the third inorganic film layer 111d overlapped with the drain area of the active layer 112a.

The drain electrode 112d and the source electrode 112c may be made of the same metal material. For example, each of the drain electrode 112d and the source electrode 112c may be made of a single metal layer, a single layer of an alloy or a multi-layer of two or more layers, which is the same as or different from that of the gate electrode.

In addition, the circuit area may further include first and second switching thin film transistors disposed together with the thin film transistor 112, and a capacitor. Since each of the first and second switching thin film transistors is provided on the circuit area of the subpixel SP to have the same structure as that of the thin film transistor 112, its description will be omitted. The capacitor (not shown) may be provided in an overlap area between the gate electrode 112b and the source electrode 112c of the thin film transistor 112, which overlap each other with the interlayer insulating layer 111b interposed therebetween.

Additionally, in order to prevent a threshold voltage of the thin film transistor provided in a pixel area from being shifted by light, the display panel or the substrate 110 may further include a light shielding layer LS provided below the active layer 112a of at least one of the thin film transistor 112, the first switching thin film transistor or the second switching thin film transistor. The light shielding layer may be disposed between the substrate 110 and the active layer 112a to shield light incident on the active layer 112a through the substrate 110, thereby minimizing a change in the threshold voltage of the transistor due to external light. Also, since the light shielding layer is provided between the substrate 110 and the active layer 112a, the thin film transistor may be prevented from being seen by a user.

The fourth inorganic film layer 111e can be provided on the substrate 110 to cover the pixel area. The fourth inorganic film layer 111e may cover the drain electrode 112d, the source electrode 112c, the gate electrode 112b of the thin film transistor (112), and the second inorganic film layer 111b.

On the other hand, as shown in FIG. 4, the pixel power line EVDD may be disposed to partially overlap the bank 115 in the third direction (Z-axis direction), and as shown in FIG. 5, the reference line RL may not overlap the bank 115 in the third direction (Z-axis direction). The fourth inorganic film layer 111e may be formed over the circuit area and the light emission area. The fourth inorganic film layer 111e may be omitted.

The planarization layer 113 may be provided on the substrate 110 to cover the fourth inorganic film layer 111e. When the fourth inorganic film layer 111e is omitted, the planarization layer 113 may be provided on the substrate 110 to cover the circuit area (or the thin film transistor 112). The planarization layer 113 may be formed in the circuit area CA in which the thin film transistor 112 is disposed and the light emission area EA. In addition, the planarization layer 113 may be formed in the other non-display area NDA except a pad area PA of the non-display area NDA and the entire display area DA. For example, the planarization layer 113 may include an extension portion (or an enlarged portion) extended or enlarged from the display area DA to the other non-display area NDA except the pad area PA. Therefore, the planarization layer 113 may have a size relatively wider than that of the display area DA.

The planarization layer 113 according to one example may be formed to have a relatively thick thickness, thereby providing a flat surface on the display area DA and the non-display area NDA. For example, the planarization layer 113 may be made of an organic material such as photo acryl, benzocyclobutene, polyimide and fluorine resin.

On the other hand, the upper surface of the planarization layer 113 can be provided flatly. Accordingly, the pixel electrodes 114 on the planarization layer 113 can also be provided flatly, and the organic light emitting layer 116 and the opposing electrode 117 formed thereon can also be provided flatly. Since the pixel electrode 114, the organic light emitting layer 116, the opposing electrode 117, that is, the light emitting element layer E is provided to be flat in the light emission area EA, a thickness of each of the pixel electrode 114, the organic light emitting layer 116 and the opposing electrode 117 in the light emission area EA may be uniformly formed. Therefore, the organic light emitting layer 116 may be uniformly emitted without deviation in the light emission area EA.

The pixel electrodes 114 according to one example can be formed on the planarization layer 113. Since the plurality of lines are arranged between the planarization layer 113 and the substrate 110, the pixel electrode 114 can be arranged on at least one of the plurality of lines. The pixel electrode 114 may be connected to a drain electrode or a source electrode of the thin film transistor 112 through a contact hole passing through the planarization layer 113 and the fourth inorganic film layer 111e. The one edge portion of the pixel electrode 114 may be covered by the bank 115. The pixel electrode 114 may be made of at least one of a transparent metal material or a semi-transmissive metal material.

Since the transparent display apparatus 100 according to one embodiment of the present disclosure is top-emission type, the pixel electrodes 114 can be made of a highly reflective metallic material or a stacked structure of a highly reflective metallic material and a transparent metallic material. For example, the first electrode 114 may be formed of a metal material having high reflectance, such as a stacked structure (Ti/Al/Ti) of aluminum and titanium, a stacked structure (ITO/Al/ITO) of aluminum and ITO, an Ag alloy, and a stacked structure (ITO/Ag alloy/ITO) of Ag alloy and ITO. The Ag alloy may be an alloy such as silver (Ag), palladium (Pd), and copper (Cu).

Meanwhile, the material constituting the pixel electrode 114 may include MoTi. The pixel electrode 114 may be a first electrode or an anode electrode.

The bank 115 may be an area, which does not emit light, and disposed on one side of the light emission area EA of each of the plurality of sub-pixels SP. For example, the bank 115 may be disposed in the non-light emission area NEA (or the non-transmissive area NTA). The bank 115 may be formed to cover the edge portion of the pixel electrode 114. Accordingly, the bank 115 may prevent the edge portion of the pixel electrode 114 from being electrically connected to the opposing electrode 117. The exposed portion of the pixel electrode 114 that is not covered by the bank 115 may be included in the light emitting portion (or light emission area EA).

After the bank 115 is formed, an organic light emitting layer 116 may be formed to cover the pixel electrodes 114 and the bank 115. Thus, the bank 115 may be provided between the pixel electrodes 114 and the organic light emitting layer 116. The bank 115 may be expressed in terms of a pixel-defining membrane. The bank 115 according to one example may comprise organic material and/or inorganic material.

Meanwhile, the bank 115 may be arranged between one of the plurality of colored subpixels and the white subpixel. For example, as shown in FIG. 5, the bank 115 may be arranged between the white subpixel SP2 and the first subpixel SP1 which is a green subpixel. In this case, the bank 115 may be provided to cover a portion of each of the pixel electrode 114 of the first subpixel SP1 and the pixel electrode 114 of the second subpixel SP2. Since the area where the bank 115 is arranged is the non-light emission area NEA (or the non-transmissive area NTA), the bank 115 may partially overlap with the black matrix BM arranged in the non-light emission area NEA (or a non-transmissive area NTA).

In a transparent display apparatus 100 according to one embodiment of the present disclosure, a width BMW of the black matrix BM may be provided narrower than a width BW of the bank 115. This is to prevent the black matrix BM from covering the light-emission area EA when the alignment is not correct when bonding the opposing substrate 200 provided with the black matrix BM and the substrate 110 (or lower substrate) provided with the light-emitting element layer E. If the width of the black matrix is equal to or greater than the width of the bank, the black matrix covers the light emission area when the alignment of the opposing substrate and the lower substrate is not correct, which reduces the light efficiency. Therefore, in the transparent display apparatus 100 according to one embodiment of the present disclosure, the width BMW of the black matrix BM between the colored subpixel and the white subpixel SP2 is provided to be narrower (or smaller) than the width BW of the bank 115, so that even if a misalignment occurs, a reduction in light efficiency can be prevented.

In contrast, the width of the black matrix BM between the colored subpixel and the transmissive area TA may be provided to be larger than the width of the bank 115. As shown in FIG. 4, the black matrix BM between the colored subpixel (or the first subpixel SP1) and the transmissive area TA protrudes further toward the transmissive area TA than the first protective electrode PE1 so that the first protective electrode PE1 is not visible to the user. Here, the fact that the black matrix BM protrudes further toward the transmissive area TA may mean that the black matrix BM is formed by being positioned (or shifted) toward the transmissive area TA. Accordingly, as shown in FIG. 4, the black matrix BM between the transmissive area TA and the colored subpixel (or the first subpixel SP1) may be arranged closer to the transmissive area TA than the bank 115, so that even if misalignment occurs, the black matrix BM does not cover the light emission area EA of the colored subpixel. As a result, the transparent display apparatus 100 according to one embodiment of the present disclosure may have a structural feature in which the width of the black matrix BM between the colored subpixel and the transmissive area TA is provided to be wider (or larger) than the width of the bank 115.

Meanwhile, as shown in FIG. 5, the second data line DL2, the reference line RL, and the third data line DL3 may be arranged to overlap with the bank 115 in the third direction (Z-axis direction). However, this is not limited thereto, and the second data line DL2 and the third data line DL3 may be arranged to not overlap with the bank 115. Since the transparent display apparatus 100 according to one embodiment of the present disclosure is a top-emission type, even if each of the second data line DL2 and the third data line DL3 overlaps the light-emission area EA of the corresponding subpixel, it may not be recognized by the user.

Referring again back to FIG. 4, the organic light emitting layer 116 may be formed on the pixel electrodes 114 and the bank 115. According to one example, the organic light emitting layer 116 may be disposed in the light emission area EA and the non-light emission area NEA. The organic light emitting layer 116 may be provided between the pixel electrode 114 and the opposing electrode 117. Thus, when a voltage is applied to each of the pixel electrode 114 and the opposing electrode 117, an electric field is formed between the pixel electrode 114 and the opposing electrode 117. Therefore, the organic light emitting layer 116 may emit light. The organic light emitting layer 116 may be formed of a plurality of subpixels SP and a common layer provided on the bank 115.

The organic light emitting layer 116 according to an embodiment may be provided to emit white light. The organic light emitting layer 116 may include a plurality of stacks which emit lights of different colors. For example, the organic light emitting layer 116 may include a first stack, a second stack, and a charge generating layer (CGL) provided between the first stack and the second stack. The light emitting layer may be provided to emit the white light, and thus, each of the plurality of subpixels SP may include a color filter CF suitable for a corresponding color.

The first stack may be provided on the pixel electrode 114 and may be implemented a structure where a hole injection layer (HIL), a hole transport layer (HTL), an emission layer (EML(B)), and an electron transport layer (ETL) are sequentially stacked.

The charge generating layer may supply an electric charge to the first stack and the second stack. The charge generating layer may include an N-type charge generating layer for supplying an electron to the first stack and a P-type charge generating layer for supplying a hole to the second stack. The N-type charge generating layer may include a metal material as a dopant.

The second stack may be provided on the first stack and may be implemented in a structure where a hole transport layer (HTL), a yellow-green (YG) emission layer (EML(YG)), and an electron injection layer (EIL) are sequentially stacked.

In the display apparatus 100 according to an embodiment of the present disclosure, because the organic light emitting layer 116 is provided as a common layer, the first stack, the charge generating layer, and the second stack may be arranged all over the plurality of subpixels SP. The organic light emitting layer 116, according to another example, may be provided in a three-stacked structure or a four-stacked structure, depending on the number of stacks stacked.

The opposing electrode 117 may be formed on the organic light emitting layer 116. The opposing electrode 117 may be disposed in the light emission area EA and the non-light emission area NEA. The opposing electrode 117 according to one example may include a metal material. The opposing electrode 117 may reflect the light emitted from the organic light emitting layer 116 in the plurality of subpixels SP toward the lower surface of the substrate 110. Therefore, the display apparatus 100 according to one embodiment of the present disclosure may be implemented as a bottom emission type display apparatus.

Since the transparent display apparatus 100 according to one embodiment of the present disclosure is top-emission type, the opposing electrodes 117 can be formed of a transparent conductive material TCO such as ITO, IZO, that is capable of transmitting light or a semi-transmissive conductive material TMCM such as magnesium (Mg), silver (Ag), or an alloy of magnesium (Mg) and silver (Ag). Such opposing electrodes 117 can be referred in terms of second electrodes, cathode electrodes.

The filling layer 118 is formed on the opposing electrodes 117. The filling layer 118 serves to prevent oxygen or moisture from penetrating into the organic light emitting layer 116 and the opposing electrodes 117. To this end, the filling layer 118 can be configured to include a getter capable of absorbing oxygen or moisture. Alternatively, the filling layer 118 can comprise a plurality of layers including at least one inorganic film layer and at least one organic film layer.

On the other hand, as shown in FIG. 4, the filling layer 118 can be disposed not only in the light emission area EA but also in the non-light emission area NEA. Additionally, the filling layer 118 can also be placed in the transmissive area TA. The filling layer 118 can be disposed between the opposing electrodes 117 and the opposing substrate 200.

An upper organic film layer 119 covering the color filter CF and the black matrix BM may be placed between the filling layer 118 and the opposing substrate 200. The upper organic film layer 119 is provided to cover the color filter CF and the black matrix BM) thereby flattening one surface of the opposing substrate 200 bonded to the substrate 110. Therefore, the transparent display apparatus 100 according to one embodiment of the present disclosure can have improved reliability against impact as the adhesive strength between the substrate 110 and the opposing substrate 200 is improved through the upper organic film layer 119.

The color filter CF and the black matrix BM may be placed between the upper organic film layer 119 and the opposing substrate 200. As described above, the white subpixel SP2 may not be provided with a color filter because the organic light-emitting layer 116 emits white light. On the other hand, a first color filter CF1 (or a green color filter CF1) may be provided between the upper organic film layer 119 and the opposing substrate 200 in the green subpixel SP1. In the blue subpixel SP3, a second color filter CF2 (or a blue color filter CF2) may be provided between the upper organic film layer 119 and the opposing substrate 200. In the red subpixel SP4, a third color filter CF3 (or a red color filter CF3) may be provided between the upper organic film layer 119 and the opposing substrate 200. As shown in FIG. 4, the color filter CF may be provided to partially cover the black matrix BM.

On the other hand, the black matrix BM can be provided between the plurality of sub-pixels SP1, SP2, SP3, SP4 to prevent color mixing and/or light leakage. However, in order to improve the area of the transmissive area TA, the black matrix BM may not be arranged between the white subpixel SP2 and the transmissive area TA. In addition, since the second subpixel SP2 is provided to emit white light, color mixing may not occur even if the black matrix BM is not arranged between the second subpixel SP2 and the transmissive area TA. Therefore, the transparent display apparatus 100 according to one embodiment of the present disclosure may have a structural feature in which the black matrix BM is not arranged between the second subpixel SP2 and the transmissive area TA.

The black matrix BM may be formed of a black series material. At least a portion of the black matrix BM may be arranged to overlap with the bank 115. The area provided with the black matrix BM and/or the bank 115 can be a dead zone or the non-light emission area. The black matrix BM according to an example can be formed on an opposing substrate 200 to overlap at least a portion of the bank 115, thereby reducing the cell gap between the organic light emitting layer 116 and the opposing substrate 200 to prevent mixing of sub-pixels.

Referring to FIG. 4, in a transparent display apparatus 100 according to one embodiment of the present disclosure, the third inorganic film layer 111d and the fourth inorganic film layer 111e may overlap the transmissive area TA. As described above, the step portion STP formed by removing the first inorganic film layer 111a including SiNₓ and the second inorganic film layer 111b including SiO₂ can be arranged to overlap on the outermost signal line (e.g., the pixel power line EVDD or the common power line EVSS). Accordingly, the first inorganic film layer 111a and the second inorganic film layer 111b may be disposed only in the non-transmissive area NTA and may not be disposed in the transmissive area TA. Therefore, the third inorganic film layer 111d and the fourth inorganic film layer 111e disposed as a common layer on the second inorganic film layer 111b may be disposed in the transmissive area TA.

As shown in FIG. 4, the third inorganic film layer 111d and the fourth inorganic film layer 111e are arranged to extend to the transmissive area TA while covering the first protective electrode PE1, so that they can overlap the transmissive area TA. In addition, as shown in FIG. 4, the third inorganic film layer 111d is arranged to overlap the transmissive area TA, so that it can come into contact with the upper surface of the substrate 110.

Meanwhile, as shown in FIG. 6, the third inorganic film layer 111d and the fourth inorganic film layer 111e are arranged to extend to the transmissive area TA while covering the second protective electrode PE2, so that they can overlap the transmissive area TA. As shown in FIG. 6, the third inorganic film layer 111d is arranged to overlap the transmissive area TA so as to be in contact with the upper surface of the substrate 110.

According to one embodiment of the present disclosure, a transparent display apparatus 100 may have the gate line GL arranged to be long in the second direction (X-axis direction) between the first sub-pixel SP1 and the third sub-pixel SP3 and between the second sub-pixel SP2 and the fourth sub-pixel SP4. In contrast, the outermost signal line (e.g., the pixel power line EVDD) can be arranged long in the first direction (Y-axis direction). Accordingly, the outermost signal line (e.g., the pixel power line EVDD) and the gate line GL can be arranged to intersect. In addition, the plurality of protective electrodes PE electrically connected to the outermost signal line (e.g., the pixel power line EVDD) may be arranged spaced apart from each other with the gate line GL therebetween. Accordingly, the plurality of protective electrodes PE may be provided in an island shape.

Meanwhile, the gate line GL can apply a different voltage (or signal) to the subpixel (SP) than the outermost signal line (e.g., the pixel power line EVDD). Therefore, as illustrated in FIG. 7, the gate line GL can be arranged spaced apart from the outermost signal line (e.g., the pixel power line EVDD). For example, the gate line GL can be arranged to be spaced apart from the outermost signal line (e.g., the pixel power line EVDD) with the first inorganic film layer 111a, the second inorganic film layer 111b, and the gate insulating layer 111c therebetween, so that the gate line GL can be insulated from the outermost signal line (e.g., the pixel power line EVDD). Accordingly, the transparent display apparatus 100 according to one embodiment of the present disclosure may have a structure in which each of the plurality of protective electrodes PE electrically connected to the outermost signal line (e.g., the pixel power line EVDD) is not electrically connected to a gate line GL.

As shown in Fig. 7, the gate line GL can partially cover the step portion STP. This is because the gate line GL is arranged to be long in the second direction (X-axis direction). As shown in Fig. 7, the gate line GL covering the step portion STP can be arranged to be spaced apart from the outermost signal line (e.g., the pixel power line EVDD) and cover the outermost signal line (e.g., the pixel power line EVDD).

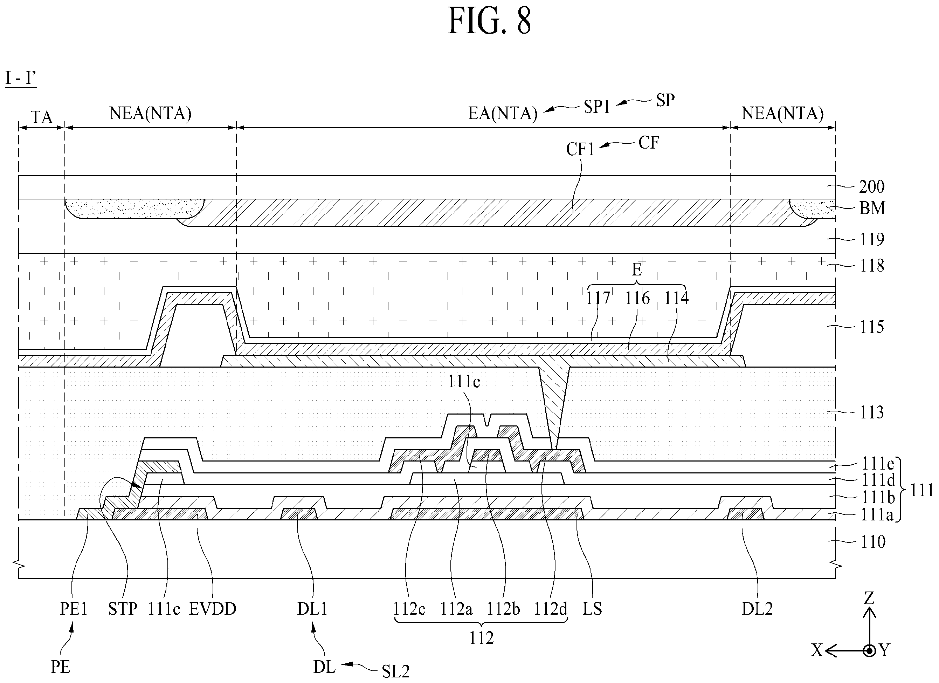

FIG. 8 is schematic cross-sectional view showing a transparent display apparatus according to another embodiment of the present disclosure.

Referring to FIG. 8, the transparent display apparatus 100 according to another embodiment of the present disclosure is identical to the transparent display apparatus according to FIG. 1 above, except that the structures of the third inorganic film layer 111d and the fourth inorganic film layer 111e are changed. Therefore, the same drawing symbols have been assigned to the same configuration, and only the different configurations will be described hereinafter.

In the case of the transparent display apparatus according to Fig. 1, the third inorganic film layer 111d and the fourth inorganic film layer 111e may be provided as a common layer. Accordingly, in the case of the transparent display apparatus according to Fig. 1, the third inorganic film layer 111d and the fourth inorganic film layer 111e may be provided so as to overlap the transmissive area TA. Accordingly, in the case of the transparent display apparatus according to Fig. 1, the third inorganic film layer 111d and the fourth inorganic film layer 111e are also arranged in the transmissive area TA, thereby preventing moisture and oxygen from penetrating into the light-emitting element layer E through the substrate 110.

In contrast, in the case of the transparent display device according to FIG. 8, the third inorganic film layer 111d and the fourth inorganic film layer 111e may be provided so as not to be placed in the transmissive area TA. For example, as shown in FIG. 8, the end of the third inorganic film layer 111d and the end of the fourth inorganic film layer 111e may be placed on the outermost signal line (e.g., the pixel power line EVDD) (or step portion STP). Accordingly, in the case of the transparent display apparatus according to Fig. 8, the end of the third inorganic film layer 111d and the fourth inorganic film layer 111e are provided so as not to be positioned in the transmissive area TA, so that the improvement in the transmittance (or transmittance) of the transmissive area TA can be maximized.

Meanwhile, as shown in FIG. 8, a transparent display apparatus 100 according to another embodiment of the present disclosure may have a structural feature in which the third inorganic film layer 111d and the fourth inorganic film layer 111e are not arranged in the transmissive area TA, so that the planarization layer 113 comes into contact with the upper surface of the substrate 110 in the transmissive area TA.

In addition, the transparent display apparatus 100 according to another embodiment of the present disclosure may be provided such that each end of the third inorganic film layer 111d and the fourth inorganic film layer 111e is positioned on the outermost signal line (e.g., the pixel power line EVDD and/or the common power line EVSS), so that the outermost signal line (the pixel power line EVDD and/or the common power line EVSS) may cover another step portion (or a second step portion) formed by the third inorganic film layer 111d and the fourth inorganic film layer 111e. Accordingly, in the transparent display apparatus 100 according to another embodiment of the present disclosure, the step portion STP formed by the first inorganic film layer 111a and the second inorganic film layer 111b, and another step portion (or a second step portion) formed by the third inorganic film layer 111d and the fourth inorganic film layer 111e are covered by the outermost signal line (e.g., the pixel power line EVDD and/or the common power line EVSS), so that the diffraction phenomenon is prevented and the clarity of an object or image can be improved.

In the present disclosure, the step portion of the inorganic film layer is arranged to overlap with the outermost signal line arranged at the edge portion of the non-transmissive area, thereby improving the clarity of objects or images shown to the user through the transmissive area.

In the present disclosure, an inorganic film layer having a different refractive index is removed from a transmissive area, so that the transmittance of the transmissive area may be improved.

In the present disclosure, since the auxiliary electrode covering the step portion is provided to be connected to the outermost signal line, a voltage drop at a center portion of the display panel may be prevented, so that a luminance of an edge portion and the center portion of the display panel may be made uniform even with low power, so that the overall power consumption may be reduced.

## Claims

1. A transparent display apparatus (100) comprising:
a substrate (110) including a display area (DA) having a transmissive area (TA) and a non-transmissive area (NTA) in which a plurality of subpixels (SP) are arranged;
a plurality of inorganic film layers (111) provided on the substrate (110);
an outermost signal line (EVDD, EVSS) arranged below an inorganic film layer (111a) at the lowermost side among the plurality of inorganic film layers (111); and
a step portion (STP) at which at least one inorganic film layer among the plurality of inorganic film layers (111) is removed,
wherein the outermost signal line (EVDD, EVSS) is arranged at an edge portion of the non-transmissive area (NTA), and
wherein the step portion (STP) overlaps the outermost signal line (EVDD, EVSS).

2. The transparent display apparatus (100) of claim 1, wherein the step portion (STP) is formed by removing a first inorganic film layer (111a) and a second inorganic film layer (111b) disposed on the first inorganic film layer (111a) and having a different refractive index from the first inorganic film layer (111a),
wherein, preferably, the first inorganic film layer (111a) includes SiNₓ and the second inorganic film layer (111b) includes SiO₂.

3. The transparent display apparatus (100) of claim 2, wherein the first inorganic film layer (111a) and the second inorganic film layer (111b) are arranged to overlap only in the non-transmissive area (NTA);
wherein, preferably:
the plurality of inorganic film layers (111) further include a third inorganic film layer (111d) disposed on the second inorganic film layer (111b) and a fourth inorganic film layer (111e) disposed on the third inorganic film layer (111d), wherein the third inorganic film layer (111d) and the fourth inorganic film layer (111e) overlap in the transmissive area (TA);
wherein, further preferably:
the third inorganic film layer (111d) is in contact with an upper surface of the substrate (110) in the transmissive area (TA);
wherein, further preferably:
an end of the third inorganic film layer (111d) and an end of the fourth inorganic film layer (111e) are arranged on the outermost signal line (EVDD, EVSS);
wherein, further preferably:
the transparent display apparatus (100) further comprises a planarization layer (113) disposed on the fourth inorganic film layer (111e), and the planarization layer (113) contacts an upper surface of the substrate (110) in the transmissive area (TA).

4. The transparent display apparatus (100) of claim 2 or 3, wherein the first inorganic film layer (111a) is in contact with an upper surface of the substrate (110) in the non-transmissive area (NTA), partially covering the outermost signal line (EVDD, EVSS).

5. The transparent display apparatus (100) of any of claims 1 to 4, wherein the substrate (110) further includes a plurality of protective electrodes (PE) covering the step portion (STP) and a portion of the outermost signal line (EVDD, EVSS).

6. The transparent display apparatus (100) of claim 5, wherein each of the plurality of protective electrodes (PE) covers the end of the outermost signal line (EVDD, EVSS), and/or
wherein each of the plurality of protective electrodes (PE) covering the step portion (STP) has a step.

7. The transparent display apparatus (100) of claim 5 or 6,
wherein the substrate (110) further includes a black matrix (BM) arranged between the plurality of subpixels (SP), and
wherein at least one of the plurality of protective electrodes (PE) overlaps the black matrix (BM).

8. The transparent display apparatus (100) of any of claims 5 to 7,
wherein the outermost signal line (EVDD, EVSS) is arranged in a first direction (Y), and
wherein each of the plurality of protective electrodes (PE) is arranged in the first direction (Y) in the non-transmissive area (NTA) and is electrically connected to the outermost signal line (EVDD, EVSS),
wherein, preferably, each of the plurality of protective electrodes (PE) is provided in an island shape.

9. The transparent display apparatus (100) of claim 8,
wherein the plurality of subpixels (SP) include a plurality of colored subpixels (SP1, SP3, SP4) and a white subpixel (SP2) arranged adjacent to each of the plurality of colored subpixels (SP1, SP3, SP4), and
wherein the plurality of protective electrodes (PE) include:
a first protective electrode (PE1) between the plurality of colored subpixels (SP1, SP3, SP4) and the transmissive area (TA); and
a second protective electrode (PE2) between the white subpixel (SP2) and the transmissive area (TA).

10. The transparent display apparatus (100) of claim 9, wherein the first protective electrode (PE1) is positioned spaced apart from the transmissive area (TA), and/or
wherein the second protective electrode is positioned adjacent to the transmissive area (TA).

11. The transparent display apparatus (100) of any of claims 8 to 10,
wherein the substrate (110) further includes a gate line (GL) arranged in a second direction (X) intersecting the first direction (Y), and
wherein the gate line (GL) is not electrically connected to each of the plurality of protective electrodes (PE).

12. The transparent display apparatus (100) of claim 11,
wherein each of the plurality of protective electrodes (PE) is arranged spaced apart from the gate line (GL), and/or
wherein each of the plurality of protective electrodes (PE) is formed of the same material as the gate line (GL).

13. The transparent display apparatus (100) of claim 11 or 12,
wherein the gate line (GL) includes a closed loop structure partially overlapping the outermost signal line (EVDD, EVSS), and
wherein each of the plurality of protective electrodes (PE) is not formed on a part of the outermost signal line (EVDD, EVSS) overlapping the closed loop structure.

14. The transparent display apparatus (100) of any of claims 11 to 13, wherein the gate line (GL) partially covers the step portion (STP).

15. The transparent display apparatus (100) of one of claim 14, wherein the part of the gate line (GL) covering the step portion (STP) is spaced apart from the outermost signal line (EVDD, EVSS) and covers the outermost signal line (EVDD, EVSS).

16. The transparent display apparatus (100) of any of claims 1 to 6, wherein the substrate (110) further includes a black matrix (BM) arranged between the plurality of sub-pixels (SP), and
wherein the step portion (STP) overlaps the black matrix (BM),
wherein, preferably:
the plurality of sub-pixels (SP) include a plurality of color sub-pixels (SP1, SP3, SP4) and a white sub-pixel (SP), and the black matrix (BM) is arranged between each of the plurality of color sub-pixels (SP1, SP3, SP4) and the transmissive area (TA), and is not arranged between the white sub-pixel (SP2) and the transmissive area (TA);
wherein, further preferably:
the substrate (110) further comprises a bank (115) between one of the plurality of colored subpixels (SP1, SP3, SP4) and the white subpixel (SP2), wherein the bank (115) partially overlaps the black matrix (BM);
wherein, further preferably, a width of the black matrix (BM) is narrower than a width of the bank (115).
